# EUROPEAN PATENT APPLICATION

(11) **EP 3 989 274 A1**
(43) Date of publication of application: **27.04.2022**
(21) Application number: 20203681.0
(22) Date of filing: 23.10.2020
(51) Int. Cl.: H01L 23/053, H01L 25/07, H01L 23/04

(54) **POWER MODULE**

(71) Applicant: SwissSEM Technologies AG, 5600 Lenzburg (CH)
(72) Inventor: Matthias, Sven, CH-5600 Lenzburg (CH); Schnell, Raffael M., CH-5703 Seon (CH); Toker, Chantal I. T., CH-5600 Lenzburg (CH)
(74) Representative: Felber, Josef

(57) **Abstract**

This power module comprises press-fit pins (34) for the electrical and mechanical connection for the terminals, insertable into sleeves (32) on the substrate (12). The substrate (12) rests on a baseplate (10). A potential alignment frame (33) ensures the accuracy of all elements. The mechanical and electrical connection of the power- and signal terminals is realized by multiple (high-current) or single press-fit connections. When inserting the pins (34), they are fitting tightly in these sleeves (32) by overcoming a frictional force and after fitting is established, for each single pin-fit, an electrical contact over a surface is established.

## Description

Power modules in the kilo watt range or above are applied in millions of units each year in industrial applications or electric vehicles. They serve for the handling of the electrical current and ensure the mechanical support of the connections. Such modules are built into inverters for electric vehicles, drives for industrial applications like elevators, fan-controller etc. The highly efficient production of these modules is as demanding as the thermal and electrical properties and the reliability levels requested by the customers. Critical is the electrical connection of the signal and power-terminals to the internal conducting layers. Presently approx. 10 million units are being manufactured annually and this manufacturing process is still challenging. The expected product lifetime is approx. 10 to 15 years.

A typical power module comprises a baseplate, attached or integrated substrates with attached chips (e.g. IGBTs, diodes, MOSFETs etc.) and wire-bonds for the electrical connections, power- and signal terminals for external busbar attachment and external controlling. The power terminals for high-currents and the signal pins are either soldered, welded or connected by multiple parallel bonded wires to the top-substrate metallization. This ensures typically low electrical resistance.

The mass production of such power modules is a challenge, technically burdensome and an enduring fight against the cost since there is an ever going on prize battle over pennies. The production requires manual handling operations with multiple soldering steps. They always have a certain potential of re-melting of previously generated solder-layers, negatively impacting the reliability. The fixtures are complex to keep all materials in place. Some terminals might mechanically shield the substrates and limit the accessibility. In summary, the production method is rather inefficient. This was the starting point to look for a better solution for such a power module.

The task of this invention is to create power modules which allow to improve the assembling, making it easier, quicker and more economic, and ensuring a stronger and better electrical and mechanical connection for all terminals and for ensuring a lowest electrical resistance. Furthermore, it is a task of this invention to provide a design for a Power Module by which a long-lifetime and safe electrical contacts can be established, and which is more economic for manufacturing lines, avoiding manual operations.

The problem is solved by a Power Module according to claim 1. The press-fit pins are being pressed into precisely positioned metal sleeves. The accuracy of the lateral position of the sleeves on the substrate is realized with an alignment frame or other methods. The sleeves can be soldered, sintered or welded to the substrate. The mechanical and electrical connection of the power- and signal terminals is realized by multiple (high-current) or single press-fit connections. Additional holes in the power-terminal can be incorporated to minimize the mechanical stress during pressing in or to minimize the impact of thermal expansion.

Simulations reveal a very low on-resistance which is up to a factor of two lower than modules of the state of the art with identical outline. The internal stray inductance is also up to a factor of two lower compared to modules of the state of the art. With the highly efficient utilization of the substrate area the world-wide highest current ratings can be achieved.

The power modules of the state of the art and then the ones according to this invention will be shown in the figures by way of example and they will be described along these figures in the following.

It shows:
- Figure 1:: An example of a state of the art power module in perspective view;
- Figure 2:: A cross-sectional view through a typical state of the art power module with typical layers;
- Figure 3:: An example of a wirebonding to power terminals in a state of the art module;
- Figure 4:: An entire state of the art power module with its electrical connections;
- Figure 5:: A power module according to invention in perspective view without housing;
- Figure 6:: The substrates and the alignment frame inside a power module according to invention in perspective view;
- Figure 7:: The power-terminal (multiple) connection of external terminals to sleeves, with sleeves inside the alignment frame matrix of a power-module according to the invention;
- Figure 8:: A power-terminal (multiple) connection of external terminals to sleeves, with a power terminal with holes or other cut-out structure to generate a stress-relief of a power-terminal inside a power-module according to the invention;
- Figure 9:: A power-terminal (multiple) connection of external terminals to sleeves, with sleeves freestanding on Cu-substrate;
- Figure 10:: An alignment frame with molded sleeves in a top view - as potential realization variant;
- Figure 11:: An entire cross-sectional view through baseplate, substrates, alignment frame and metal bridges;
- Figure 12:: An enlarged view of the central section of the alignment frame of Figure 11;
- Figure 13:: Cross-sectional view of the housing with press-fit connectors of the terminals, prior to assembly with the baseplate with the attached substrates and alignment frame.

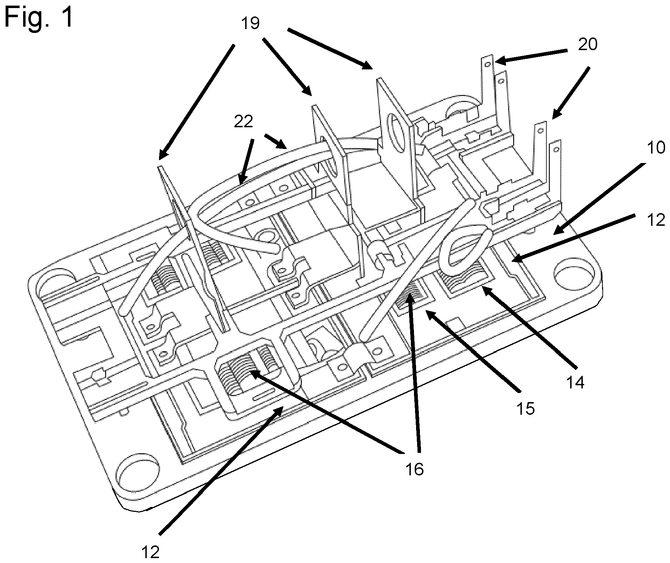

A typical power module according to the state of the art is shown in a perspective view in **Figure 1****.** 19 designates the power terminals and 20 are auxiliary signal terminals. Insulated-gate bipolar transistor 14 (IGBT) and diode 15 chips can be seen on the substrate 12. Wirebonds 16 electrically connect the chips with the substrate. The substrate 12 rests on a baseplate 10. The dimensions of the shown module base plate are about 62 x 106 mm². Manually assembled wires 22 electrically connect the signal terminal to the substrate.

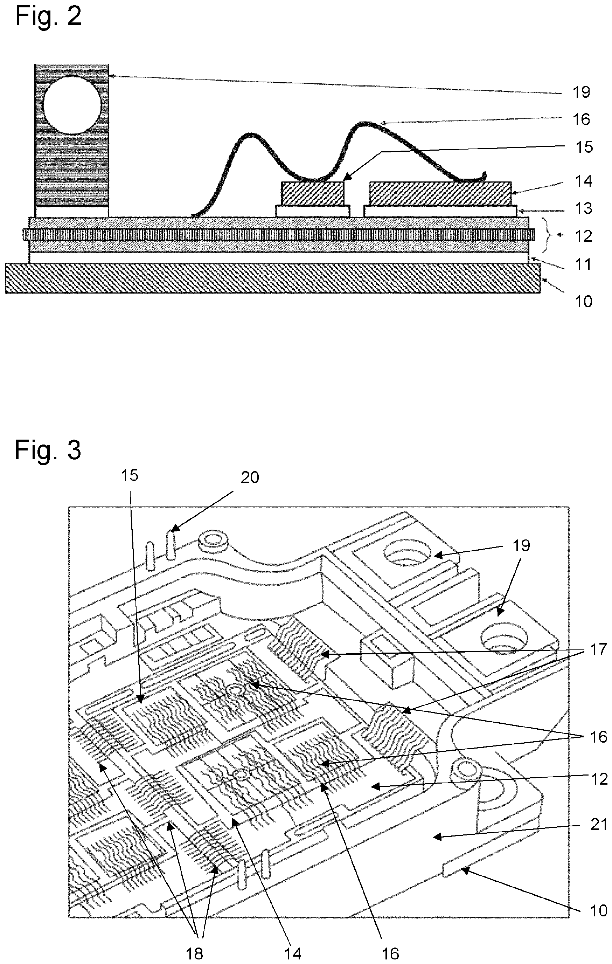

A typical power module according to the state of the art is shown in a cross-section in **Figure 2****.** It comprises a baseplate 10, attached or integrated substrates 12 on a solder or sinter layer 11 with attached chips 14/15 (e.g. IGBTs, diodes , MOSFETs etc.) on a solder/sinter layer 13 which is put onto the top layer of the substrate 12, wire-bonds 16 for the electrical connections, power terminals 19 - and signal terminals for external busbar attachment and external controlling. The power terminals 19 for high-currents and the signal pins are either soldered, welded, or connected by multiple parallel bonded wires to the top-substrate metallization. This ensures typically a low electrical resistance.

**Figure 3** shows a section of the interior of a power module with the Insulated-Gate Bipolar Transistors (IGBT) 14 and diode 15 chips on the substrate 12. Wirebonds 16 electrically connect the chips with the substrate. Power terminals 19 are connected electrically with wirebonds 17 to the substrate 12. The substrate to substrate connection is done with wirebonds 18. On top of the baseplate 10 there is a housing 21 typically made of plastic or of molded resin material. Typically, the housing 21 is glued to the baseplate 10. Sometimes it is mechanically supported by screws or crimped rivets. For some module types the housing 21 is done by injection molding and contains metal parts, e.g. signal terminals 20 or power terminals 19.

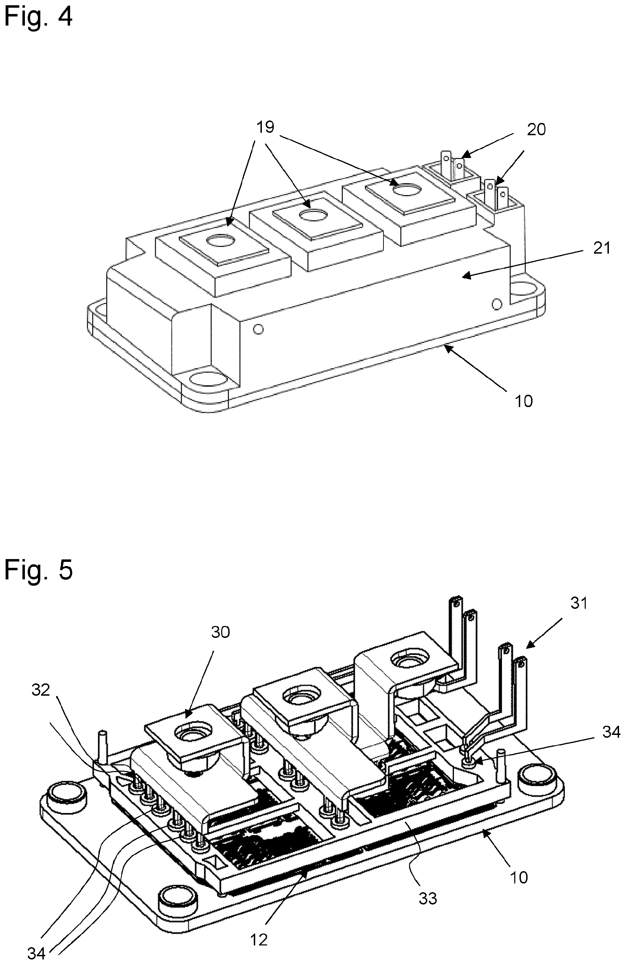

**Figure 4** shows a typical state of the art power module of 62mm width, with its baseplate 10, housing 21 on top of the baseplate 10 and the electrical connections 19 on its top and the signal terminals 20.

The power module according to the present invention has as a different design and is shown in **Figure 5** in a perspective view. It still comprises a baseplate 10 and a conducting substrate layer 12. The electrical connections are realized by press-fit connectors 32. There is a single press-fit 34 for a signal terminal 31, and multiple parallel press-fit pins 34 for power terminals 30. Press-fit pins 34 undergo a mechanical friction while being inserted into previewed holes or sleeves 32 in the conducting substrate layer 12 and ultimately provide an entire conducting surface for the electrical connection. Such connections prove to be reliable. So far, press-fits are commonly used to connect to Printed Circuit Boards. When used at the busbar/gate-unit drive side in applications, why not use them within a power module? For the realization, multiple sleeves 32 are attached to the top of the substrate layer 12 and the press-fit terminals 30, 31 are simply pressed into these holes or sleeves 32. This can be achieved in a matter of seconds. The technical challenge is the alignment accuracy which is less than 0.1 mm. This accuracy requirement can be realized, for example, by an alignment frame 33, which might be therefore incorporated into the module. There are other ways to achieve such alignment.

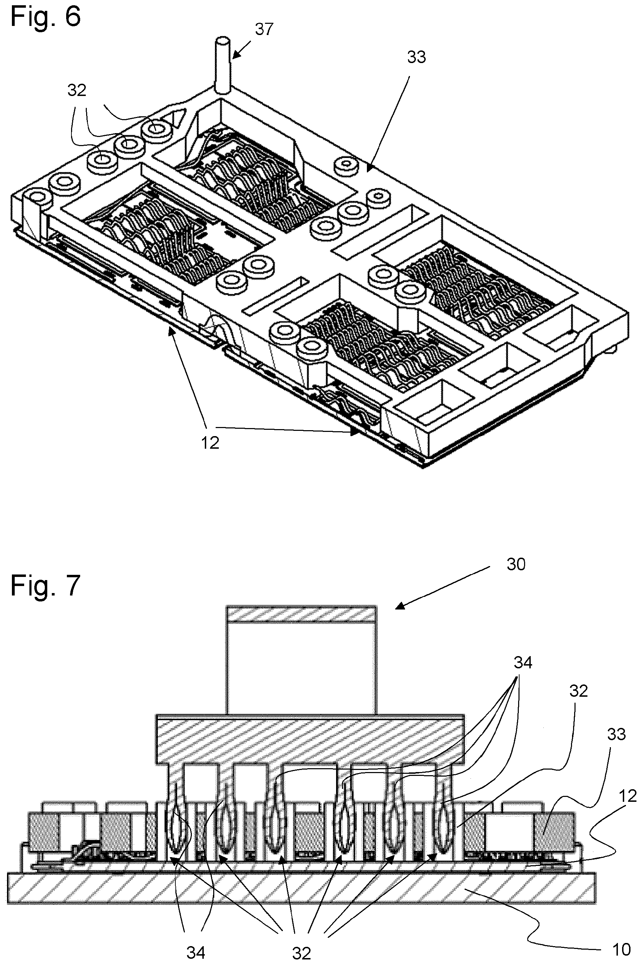

In **Figure 6****,** a substrate 12 with the alignment frame 33 and the sleeves 32 in the alignment frame is shown in a perspective view. An alignment feature 37 is positioned on the alignment frame 33 for accurate positioning and guiding of the housing to the sleeves 32 and alignment frame 33.

**Figure 7** shows the power module in a section view. It comprises a baseplate 10 on which a substrate layer 12 is put on. This substrate layer 12 can be, but not necessarily, positioned by an alignment frame 33. This alignment frame 33 itself holds several sleeves 32 which are arranged in that frame 33 and are soldered onto the substrate layer 12. These sleeves 32 offer a great stability within the alignment frame 33. As shown, there is an array of press-fit pins 34 which are preferably made of one single material block, and they fit into the sleeves 32 in the alignment frame 33. Each press-fit pin 34 splits in at least two elastic twigs which enclose a space in between and extend to a common tip. These twigs are elastically squeezable in traverse direction of the pin, that is to each other, thereby making the space between them smaller. Executions with three, four or more such twigs are possible. When the press-fit pins 34 are pressed into the sleeves 32 with their tips ahead, the elastic twigs ensure they will be inserted by creating a friction force along the inner side of the sleeves 32 and ultimately assume a strong press-fit within the sleeve 32 and ensure a good electrical contact over adjacent surfaces of the pin and the inner side of the sleeve, and the pins are also kept in the sleeve with substantial mechanical resistance. As alternative shape, the single pins can have a meandering serpentine-like shape and extend into a central tip, so the pin is elastically compressible in transverse direction and extending into a central tip. This will also create the required mechanical friction force during the inserting and for holding the pins in the sleeves. On top of this entire single material block with the pins, the power terminal 30 is mounted.

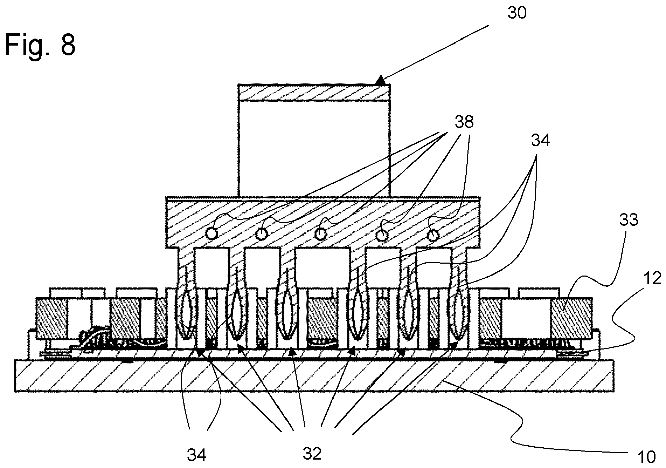

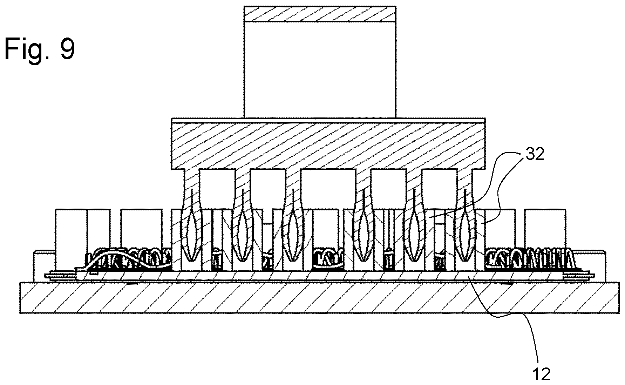

Therefore, the mechanical and electrical connection of the power- and signal terminals is realized by multiple (high-current) or single press-fit connections as shown. An additional cut-out structure 38 in the power-terminal can be incorporated as shown in **Figure 8****,** to minimize the mechanical stress during pressing in or to minimize the impact of thermal expansion during operation and storage. Finally, **Figure 9** shows sleeves 32 freestanding on the Cu-substrate 12.

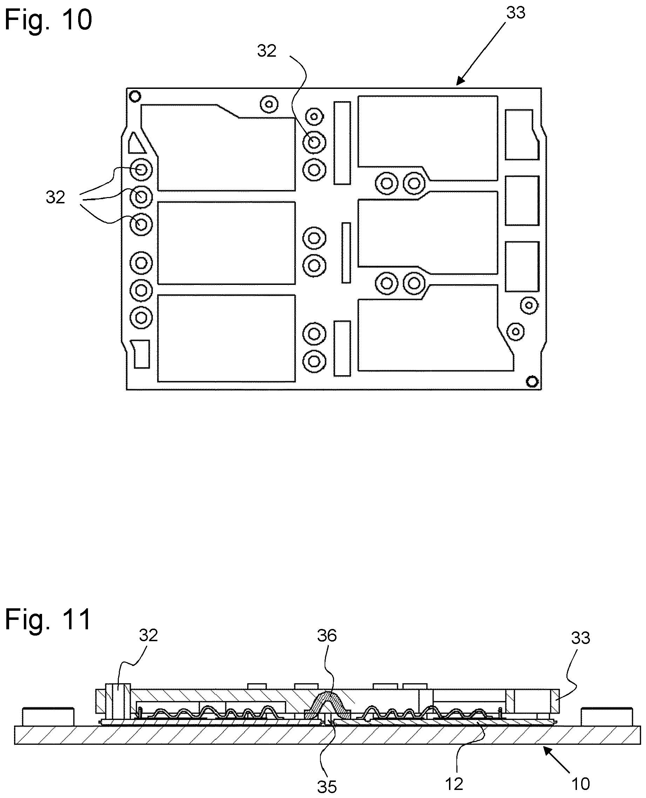

**Figure 10** shows an alignment frame 33 with molded sleeves 32. The sleeves 32 which form the female contact to the press-fit pins 34 are molded into this alignment frame 33. This generates the needed accuracy levels in the x-y plane. All sleeves 32 and the metal bridges which are electrically connecting the substrates are attached to the top-metal substrate layers during the later assembly process. The alignment frame 33 ensures the needed accuracy towards the multiple substrate top-sides and the multiple power terminals.

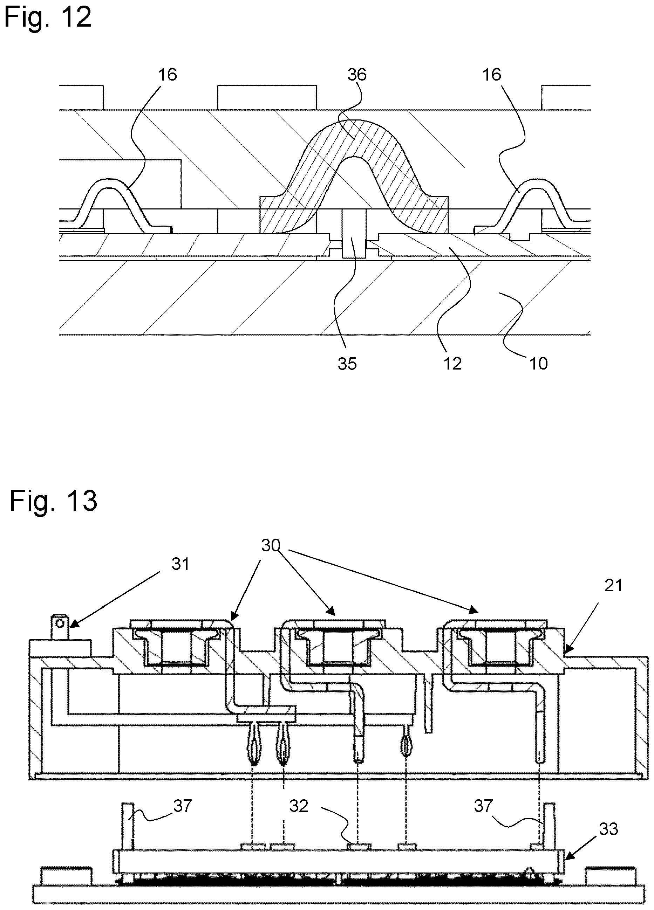

**Figure 11** shows the cross-section of the entire baseplate 10, the substrates 12 and the alignment frame 33 with the incorporated sleeves 32 and metal bridges 36, and **Figure 12** an enlarged view of the area around the central metal bridge 36. The alignment frame ensures an excellent alignment among the sleeves towards the power and the signal terminals. Moreover, it ensures an excellent substrate alignment. A spacer 35 sets a minimum distance between the substrates 12.

In **Figure 13****,** the alignment frame 33 and housing 21 are shown. This housing 21 with the molded press-fit power terminals 30 and signal terminals 31 is "guided" during assembly by the "pillars" as alignment features 37 of the alignment frame 33. With the two new elements - the alignment frame 33 and the housing block 21 - the assembly process is simplified enabling now a fully automated assembly process.

A fixture for future alignment purposes is placed on a fresh baseplate. An automatic pick-and-place is carried out to position solder-preforms and the fully bonded substrates on the baseplate 10. Subsequently the alignment-frame 33 is put on top. A high-temperature step is carried out to reliably join the materials prior to the removal of the fixture. Glue is dispensed to the housing block 21. Then the housing block 21 is mounted to the baseplate 10. A guiding feature 37 (exemplarily shown in **Figure 13**) ensures that the housing-block is well-aligned with its press-fit pins to the sleeves. The demanded accuracy is about 0.2 mm for all. With a press-in force of about 40 to 60N per pin 34 at a speed of 25 to 50 mm/s this might for a high power module result in press-in force of about 1kN per housing block. Afterwards the glue is cured and an isolation gel is applied.

This power module can be adapted for many other technical fields. Simulations reveal a very low on-resistance which is up to a factor of two lower than competitor modules with identical outline. The internal stray inductance is also up to a factor of two lower compared to competitor modules. With the highly efficient utilization of the substrate area the world-wide highest current ratings can be achieved.

### List of Numerals

- 10: Baseplate
- 11: Solder/Sinter layer baseplate to substrate
- 12: Substrate
- 13: Solder/Sinter layer substrate to chip (either IGBT or diode or MOSFET)
- 14: Insulated-gate bipolar transistor (IGBT)
- 15: Diode
- 16: Wirebonds to chip
- 17: Wirebonds to terminal
- 18: Wirebonds from substrate to substrate
- 19: Power terminal
- 20: Signal terminal
- 21: Housing
- 22: Wires for signal terminal connection
- 30: Power terminals with multiple press-fit connectors
- 31: Signal terminal with single press-fit connector
- 32: Sleeve
- 33: Alignment frame with sleeves
- 34: Single press-fit pin
- 35: Spacer / alignment feature for substrates
- 36: Metal bridge
- 37: Alignment feature for housing
- 38: Cut-out structure (represented by holes) in power terminal

## Claims

1. Power Module with housing (21), comprising press-fit pins (34) which are elastically compressible in transverse direction, for the electrical and mechanical connection for all terminals, insertable into circular metal sleeves (32) on the conductive substrate (12) on a baseplate (10) whereby the press-fit pins (34) are elastically compressed in transvers direction during insertion in order to produce a mechanical frictional force and a tight press-fit by said frictional force, establishing connecting contact surfaces between pin and inner side of the sleeve for the electrical connection.

2. Power Module according to claim 1, **characterized in that** the single pins (34) are split into at least two elastically bendable twigs which enclose a free space and extend into a common tip.

3. Power Module according to claim 1, **characterized in that** the single pins (34) are forming a meandering serpentine shape so the pin is elastically compressible in transverse direction and extending into a central tip.

4. Power Module according to one of the preceding claims, **characterized in that** the substrate (12) is combined with an alignment frame (33) with alignment features (37) for precision positioning of the housing (21).

5. Power Module according to one of the preceding claims, **characterized in that** the substrate (12) is combined with an alignment frame (33) with alignment features (35) for the positioning of the substrates (12).

6. Power Module according to one of the preceding claims, **characterized in that** the substrate (12) is combined with an alignment frame (33), and the integrated sleeves (32), which are soldered/sintered on to the substrate (13).

7. Power Module according to one of the preceding claims, **characterized in that** the mechanical and electrical connection of the power terminals (30) and signal (31) terminals are realized by multiple (high-current) or single press-fit connections (34).

8. Power Module according to one of the preceding claims, **characterized in that** additional cut-out structures (38) in the power-terminal (30) are incorporated to minimize the mechanical stress during pressing in or to minimize the impact of the thermal expansion during operation.

9. Power Module according to one of the preceding claims, **characterized in that** one or several metal bridges (36) for interconnecting the substrates (12) are positioned by an alignment frame (33).

10. Power Module according to one of the preceding claims, **characterized in that** module comprises a basic substrate (12) with sleeves (32) and press-fit pins (34) for the signal-terminal (31) and for the power-terminal (30), whereas the press-fit pins (34) are fitting tightly in these sleeves (32) by overcoming a frictional force and after fitting, an electrical contact over the surface is established.
